(19) Europäisches Patentamt / European Patent Office / Office européen des brevets

(11) **EP 3 814 743 B1**

(12) **EUROPEAN PATENT SPECIFICATION**

(45) Date of publication and mention
of the grant of the patent:
**16.02.2022 Bulletin 2022/07**

(21) Application number: **19730809.1**

(22) Date of filing: **19.06.2019**

(51) International Patent Classification (IPC):
*G01N 15/02* (2006.01)     *G01B 9/02* (2022.01)
*G01S 7/481* (2006.01)     *G01S 7/4912* (2020.01)
*G01S 17/04* (2020.01)     *H01S 5/183* (2006.01)
*G01N 15/14* (2006.01)     *G01N 15/06* (2006.01)
*H01S 5/00* (2006.01)       *H01S 5/026* (2006.01)
*H01S 5/06* (2006.01)

(52) Cooperative Patent Classification (CPC):
**G01N 15/06; G01B 9/02092; G01N 15/1431;**
**G01N 15/1434; G01N 15/1456; G01S 7/4812;**
**G01S 7/4916; G01S 17/04; H01S 5/0028;**
**H01S 5/18302; H01S 5/18341;** G01N 2015/0038;
G01N 2015/0046; G01N 2015/0693;
G01N 2015/1454;                              (Cont.)

(86) International application number:
**PCT/EP2019/066159**

(87) International publication number:
**WO 2020/002075 (02.01.2020 Gazette 2020/01)**

(54) **LASER SENSOR MODULE WITH ELECTRO-OPTICAL MODULATOR**

LASERSENSORMODUL MIT ELEKTROOPTISCHEM MODULATOR

MODULE DE CAPTEUR LASER COMPORTANT UN MODULATEUR ÉLECTRO-OPTIQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **29.06.2018 EP 18180800**

(43) Date of publication of application:
**05.05.2021 Bulletin 2021/18**

(73) Proprietor: **TRUMPF Photonic Components GmbH**
**89081 Ulm (DE)**

(72) Inventor: **GERLACH, Philipp Henning**
**89081 Ulm (NL)**

(74) Representative: **Trumpf Patentabteilung**
**Trumpf GmbH & Co KG**
**TH550 Patente und Lizenzen**
**Johann-Maus-Straße 2**
**71254 Ditzingen (DE)**

(56) References cited:
WO-A1-2018/104154     DE-A1-102015 207 289
GB-A- 2 407 156       JP-A- S61 294 334

• J Van Eisden ET AL: "Monolithic Integration of an Electroabsorption Modulator into a GaAs-based Duo-cavity VCSEL for Resonance-free Modulation", CS Mantech Conference, Chicago, Illinois, USA, 14 April 2008 (2008-04-14), pages 1-4, XP055530064, Retrieved from the Internet: URL:https://www.researchgate.net/profile/V adim_Tokranov2/publication/238509535_Monol ithic_Integration_of_an_Electroabsorption_ Modulator_into_a_GaAs-based_Duo_cavity_VC S EL_for_Resonance-free_Modulation/links/004 635278200f96d49000000/Monolithic-Integrati on-of-an-Electroabsorption-Modulator-into- a-GaAs-bas [retrieved on 2018-12-04]

- **BERNAT I ET AL: "Optical particle detection in liquid suspensions with a hybrid integrated microsystem", SENSORS AND ACTUATORS A: PHYSICAL, ELSEVIER BV, NL, vol. 247, 4 June 2016 (2016-06-04), pages 629-640, XP029713763, ISSN: 0924-4247, DOI: 10.1016/J.SNA.2016.06.003**

(52) Cooperative Patent Classification (CPC): (Cont.)
H01S 5/0262; H01S 5/0614

**Description**

FIELD OF THE INVENTION

The invention relates to a laser sensor module with electro-optical modulator, a laser sensor comprising such a laser sensor module, a particle detector comprising such a laser sensor and a mobile communication device comprising such a laser sensor or particle detector. The invention further relates to a corresponding method of detecting particles.

BACKGROUND OF THE INVENTION

DE 10 2015 207 289 A1 discloses a laser sensor module for interference based particle detection. The laser sensor module comprises a Vertical Cavity Surface Emitting Laser, and a light detector, wherein the Vertical Cavity Surface Emitting Laser comprises a first electrical contact, a second electrical contact and an optical resonator. The optical resonator comprises an active layer. The Vertical Cavity Surface Emitting Laser is arranged to emit laser light during operation of the Vertical Cavity Surface Emitting Laser, and the light detector is arranged to detect an optical response in reaction to the laser light emitted by the Vertical Cavity Surface Emitting Laser and scattered or reflected back into the Vertical Cavity Surface Emitting Laser. Further disclosed in this document is a method of particle detection by means of the laser sensor module, wherein laser light is emitted by the Vertical Cavity Surface Emitting Laser, and an optical response is detected by means of the light detector.

SUMMARY OF THE INVENTION

It is an object of the present invention to provide a laser sensor module with improved reliability.

According to a first aspect a laser sensor module for interference-based particle detection is provided. The laser sensor module comprises a Vertical Cavity Surface Emitting Laser (VCSEL), an electro-optical modulator and a light detector. The VCSEL comprises a first electrical contact, a second electrical contact and an optical resonator. The optical resonator is arranged to be electrically pumped by means of the first electrical contact and the second electrical contact. The optical resonator comprises a first distributed Bragg reflector (DBR), a second DBR and an active layer arranged between the first DBR and the second DBR. The VCSEL is arranged to emit laser light during operation of the VCSEL upon providing an electrical drive current above a threshold current of the VCSEL to the first electrical contact and the second electrical contact. The electro-optical modulator is integrated in the optical resonator. The electro-optical modulator is arranged to tune a resonance frequency of the optical resonator by means of an electrical tuning voltage applied to the electro-optical modulator. The light detector is arranged to detect an optical response in reaction to the laser light emitted by the VCSEL. The tuning voltage is arranged such that a detection signal caused by a macroscopic object positioned in a range between a threshold distance and a detection range of the particle sensor module is reduced in comparison to a detection signal caused by the macroscopic object at the same position without providing the tuning voltage. The detection signal is received by the light detector when providing the tuning voltage. The optical response comprises an interference and especially a self-mixing interference signal. The detection signal is reduced by means of the tuning voltage such that an essentially undisturbed measurement of a presence of small particles and especially a particle density by means of the light detector is enabled when applying the tuning voltage if the macroscopic object is present in the range between the threshold distance and the detection range. The macroscopic object may be characterized by a size of at least 0.5 cm. Interference or more specifically self-mixing particle sensor modules are currently proposed for PM 2.5 particle detection enabling a miniature particle detector that can be used in e.g. a smartphone. These interference laser sensor modules emit for example 3 laser beams. When particles travel close to a focus position through one of these beams they will be detected. Furthermore, speed of the particles can be determined from Doppler frequencies. The combination of velocity and number of detected particles yields a measure for the particle density (e.g. PM 2.5) concentration. Further details related to SMI-based particle detection are, for example, described in WO 2017/198699 A1, WO 2017/198555 A1 and WO 2017/016888 A1.

The particle sensor module should be sensitive to detect particles at the focus position being e.g. 0.5 cm from the smartphone surface. Recent experiments have shown that such laser sensor modules are sensitive with respect to macroscopic objects (e.g. hand of a user of the mobile communication device) at more than 20 cm. The measurement results or sensor readings caused by the macroscopic object may mistakenly be interpreted as particle counts. The sensor readings should be insensitive for obstruction by macroscopic or large objects at, for instance, 20 cm from the particle sensor module to enable a more reliable particle detection.

The subject laser sensor module may enable reduction of false-positive particle counts by providing a tuning voltage to the electro-optical modulator. The electro-optical modulator is arranged to change the optical length of the optical resonators by changing the refractive index of at least one material comprised by the electro-optical modulator upon providing the tuning voltage. The tuning voltage is preferably a high-frequency signal (high-frequency voltage modulation) enabling a high-frequency modulation of the resonance frequency of the optical resonator. Tuning the refractive index of a material comprised by the electro-optical modulator by means of changing voltage (or more precisely electrical field) is much faster than tuning the laser by means of a modulated drive current. The time constant for frequency change with electrical signal is expected to reduce from 0.5 $\mu$s (thermal effect by means of varying drive currents provided to the laser) down to < 0.0001 $\mu$s (electro optical effect). Together with and accordingly adapted modulation scheme, this may allow for fast tuning of emission wavelength and thus making the laser sensor module insensitive to reflected light. Even if the reflection is at ~ 10 cm (distance or position of macroscopic object with respect to the laser sensor module) distance only. While maintaining good count rate for particles at a few mm distance. The emission wavelength of the laser light emitted when providing the tuning voltage is therefore tuned in accordance with the modulation of the tuning voltage. The high-frequency signal may comprise a single frequency or a combination of two or more frequencies. The electro-optical modulator is modulated such that the received signal from a certain distance is minimized (see theoretical explanation provided below). The influence of a macroscopic object with respect to particle counts (false-positive particle counts caused by the detection signal) may therefore be reduced. The threshold distance means in this respect the distance at which a signal strength of the detection signal caused by macroscopic objects is sufficiently reduced. The threshold distance is greater than a particle sensitivity range of the laser sensor module at which particles smaller than 20 $\mu$m or smaller than 10 $\mu$m can be detected. The particle sensitivity range is usually smaller than 5 cm and may preferably be in a range between 0.4 cm and 2 cm. The particle sensitivity range may be determined by means of the beam shape of a laser beam emitted by the laser. The laser or the laser sensor module may comprise an optical device to focus the laser beam to a focus region to determine the particle sensitivity range. The threshold distance may therefore be, for example, 10 cm or 20 cm depending on the application in which the method is used and the expected distances at which macroscopic may be present. The detection range is the range in which a signal strength caused by the macroscopic object without high-frequency modulation is above a defined threshold value.

The defined threshold value may depend on the sensitivity of the laser sensor module and the intended accuracy with respect to the detection of particle densities (qualitative or quantitative measurements). The defined threshold value may preferably be chosen such that false-positive particle counts caused by the macroscopic object are less than 200 counts per 30 seconds more preferably less than 50 counts per 30 seconds.

A modulation frequency of the high-frequency signal may be chosen out of the range between 10 MHz and 500 MHz, preferably between 40 MHz and 200 MHz. Experiments have shown that suppression or false-positive particle counts in the most relevant range between 20 cm to 60 cm between the particle sensor module and the macroscopic object is best in the described frequency range. Frequencies below 40 MHz or above 200 MHz may especially be used in less sensitive applications.

Particles or more precisely particle counts may be determined in the frequency domain, using a Fast Fourier Transform (FFT) of the measurement signals provided by the light detector (e.g. interference and especially self-mixing interference measurement signals). The FFT is an algorithm that samples a signal over a period of time and divides it into bins with its frequency components. The highest frequency bin corresponds to the Nyquist frequency (Nyquist bin). The Nyquist bin of this FFT is not used for particle detection. The risk that high-frequency (HF) modulation of the laser or light detector by means of the HF signal will result in false particle detection is minimized if frequency components of the HF modulation frequency coincides with the Nyquist bin which is not used for particle detection. Practically, this means that the modulation frequency or modulation frequencies of the high-frequency signal may be chosen (n+0.5)*fs with n an natural number greater than zero. The optical response is sampled at the sample frequency fs.

A modulation amplitude of the high-frequency signal is chosen such that the detection signal is minimized in the range between the threshold distance and the detection range. A bias or DC voltage may be provided to the electro-optical modulator. The maximum modulation amplitude of the voltage modulation may be between 5% and 80%, more preferably between 20% and 60% of the bias voltage.

The reduction of the detection signal or more precisely the signal strength of the detection signal at the threshold distance may be at least one order of magnitude, preferably at least two orders of magnitude in comparison to a signal strength of the detection signal caused by the macroscopic object received without the tuning voltage and especially the high-frequency signal. The reduction of the signal strength of the detection signal within the range between the threshold distance and the detection range is preferably at least one order of magnitude, preferably at least two orders of magnitude in comparison to a signal strength of the detection signal received without the tuning voltage and especially the high-frequency signal.

The tuning voltage the arranged such that the threshold distance is less than 50 cm, preferably less than 30 cm and most preferably less than 20 cm.

The light detector according to any embodiment discussed above may be arranged to detect a self mixing interference signal resulting from an interference of the laser light emitted by the VCSEL and reflected laser light in the optical resonator.

The light detector may be integrated in the optical resonator. The arrangement of a light detector (e.g. photo diode or photo transistor) integrated in the optical resonator may especially be suited for measuring self-mixing interference signals.

The electro-optical modulator may comprise a semiconductor pin junction. The electro-optical modulator may basically consist of a semiconductor pin junction made from material which is optically transparent, but the absorption edge is close to the operating wavelength of the VCSEL. The change of refractive index with applied electric field is maximized in this case.

The electro-optical modulator may, for example, comprise a modulator layer arrangement. An optical thickness of the electro-optical modulator including the modulator layer arrangement is between $\lambda/2$ and five times $\lambda/2$ at the emission wavelength $\lambda$ of the VCSEL. The modulator layer arrangement is arranged to adapt the phase of the optical wave within the electro-optical modulator to the DBR in which the electro-optical modulator is integrated in.

The electro-optical modulator may be electrically contacted by means of a third electrical contact and a fourth electrical contact. The third electrical contact and the fourth electrical contact are different than the first electrical contact and the second electrical contact. Using different electrical contacts for electrically contacting the light detector and electro-optical modulator may enable to choose the position of the electro-optical modulator with in the optical resonator independent from the light detector. The light detector and the electro-optical modulator may be arranged in the same DBR or in different DBRs depending on the configuration of the VCSEL (e.g. top emitter or bottom emitter).

The electro-optical modulator may be electrically isolated from the first electrical contact and the second electrical contact. Electrical isolation between the electro-optical modulator and the light detector may avoid or at least reduce cross talk between tuning voltage and the detection signal detected by the light detector.

The electro-optical modulator and the light detector may alternatively share the same electrical contacts. Using the same electrical contacts may enable a simple and compact laser sensor module. The electro-optical modulator may comprise in this case a pin junction as described above. The same pin junction may be used as light detector.

The light detector may alternatively be electrically contacted by means of a fifth electrical contact and a sixth electrical contact. The fifth electrical contact and the sixth electrical contact are different than the first electrical contact, the second electrical contact, the third electrical contact and the fourth electrical contact. Providing different electrical contacts for electrically driving the laser, electrically tuning the electro-optical modulator and detecting the detection signal may simplify electrical design of the laser sensor module. Furthermore, electrical isolation between the different functions may be increased.

The VCSEL and the electro-optical modulator may alternatively share one common electrical contact.

The light detector may comprise a phototransistor. The phototransistor may be arranged to support current confinement of the electrical drive current.

The VCSEL may comprise additional layers as, for example, one or more current confinement layer (current aperture) to confine the electrical current to a defined area of the active layer.

The light detector may alternatively be separated from the VCSEL and the electro-optical modulator. The laser sensor module comprises in this embodiment a beam splitter. The light detector is arranged to detect by means of the beam splitter an interference signal resulting from an interference of the laser light emitted by the VCSEL and reflected laser light. The beam splitter is used to provide a miniaturized interferometer.

According to a further aspect a laser sensor is provided. The laser sensor comprises the laser sensor module according to any embodiment described above. The laser sensor comprises a driving circuit connected to the first electrical contact and the second electrical contact for providing an electrical drive current to the VCSEL. The laser sensor further comprises a tuning circuit. The tuning circuit is electrically connected to the electro-optical modulator for providing the tuning voltage.

The tuning circuit may be arranged to modulate the tuning voltage such that an electrical field in the modulator layer arrangement changes on average with at least $5*10^5$ V/(m*ns), preferably at least $7.5*10^5$ V/(m*ns) for at least 0.5 ns. Experiments have shown that providing tuning voltage with at least $5*10^5$ V/(m*ns) for at least 0.5 ns, more preferably at least 1 ns and most preferably at least 5 ns result in an improved suppression of false-positive particle counts caused by the macroscopic object positioned in the range between the threshold distance and the detection range.

The tuning voltage may be modulated in a triangular shape, preferably in a sawtooth shape.

According to a further aspect a particle detector is provided. The particle detector comprises the laser sensor according to any embodiment described above and an evaluator. The particle detector comprises an optical focusing device for focusing the emitted laser light to a focus region. The focus region is at a distance to the focusing device of less than 3 cm, preferably less than 2 cm and most preferably less than 1 cm. The focus region is preferably at a distance between 0.2 cm and 1 cm. The distance is smaller than the threshold distance as described above. The tuning circuit is arranged to provide the tuning voltage characterized by a modulation frequency and a modulation amplitude. The modulation frequency and the modulation amplitude are arranged such that a sensitivity with respect to the detection of detection signals related to a macroscopic object of the laser sensor is reduced at least by one order of magnitude, preferably two orders of magnitude preferably at the threshold distance, preferably in the range between the threshold distance and the detection range (e.g. at a distance to the focusing device between 20 cm and 40 cm, preferably between 15 cm and 50 cm). The evaluator is arranged to determine a particle density of particles with a size between 0.05 $\mu$m

to 10 μm, preferably between 0.1 μm and 2.5 μm (e.g. PM 2.5) based on measurement signals provided by the light detector. The particle density may be determined with respect to only a part of the ranges of particle sizes. The measurement signals may be detected by means of the light detector when applying the tuning voltage. The tuning voltage may be applied permanently or in predetermined time periods. Applying the tuning voltage in predetermined time periods (e.g. switching the tuning voltage regularly on and off) may enable detection of the macroscopic object by comparing measurement signals determined in a time period in which the tuning voltage is switched off with measurement signals determined in time periods in which the tuning voltage is switched on.

An air purifier, an exhaust hood, a car, a sensor box or a wearable device like a mobile communication device and the like may comprise the laser sensor or particle detector according to any embodiment as described above. The devices are arranged to communicate a particle density determined by means of the laser sensor or the particle detector to a user of the respective device.

According to a further aspect a method of particle detection by means of a laser sensor module comprising a Vertical Cavity Surface Emitting Laser (VCSEL), an electro-optical modulator and a light detector is provided. The VCSEL comprises a first electrical contact, a second electrical contact and an optical resonator, wherein the optical resonator comprises a first distributed Bragg reflector, a second distributed Bragg reflector and an active layer arranged between the first distributed Bragg reflector and the second distributed Bragg reflector. The electro-optical modulator is integrated in the optical resonator. The method comprises the steps of:

emitting laser light by means of the VCSEL,
tuning a resonance frequency of the optical resonator by means of an electrical tuning voltage applied to the electro-optical modulator,
detecting an optical response by means of the light detector when tuning the resonance frequency in reaction to the laser light emitted by the Vertical Cavity Surface Emitting Laser. The tuning voltage is arranged such that a detection signal caused by a macroscopic object positioned in a range between a threshold distance and a detection range of the particle sensor module is reduced in comparison to a detection signal caused by the macroscopic object at the same position without providing the tuning voltage, wherein the detection signal is received by the light detector when providing the tuning voltage.

Further advantageous embodiments are defined below.

BRIEF DESCRIPTION OF THE DRAWINGS

These and other aspects of the invention will be apparent from and elucidated with reference to the embodiments described hereinafter.

The invention will now be described, by way of example, based on embodiments with reference to the accompanying drawings.

In the drawings:

Fig. 1 shows a principal sketch of a first laser sensor module
Fig. 2 shows a principal sketch of a tuning circuit with electro-optical modulator
Fig. 3 shows the modulation amplitude dependence of compensation of the second embodiment at a modulation frequency of 93 MHz
Fig. 4 shows the modulation amplitude dependence of compensation of the second embodiment at a modulation frequency of 200 MHz
Fig. 5 shows measurement results of control measurements
Fig. 6 shows a principal sketch of a second laser sensor module
Fig. 7 shows a principal sketch of a third laser sensor module
Fig. 8 shows a principal sketch of a fourth laser sensor module
Fig. 9 shows a principal sketch of a first laser sensor
Fig. 10 shows a principal sketch of a second laser sensor
Fig. 11 shows a principal sketch of a mobile communication device
Fig. 12 shows a principal sketch of a method of particle detection
Fig. 13 shows the magnitude of the DC component for a given value of the argument of the zero order Bessel function

In the Figures, like numbers refer to like objects throughout. Objects in the Figures are not necessarily drawn to scale.

## DETAILED DESCRIPTION OF EMBODIMENTS

Various embodiments of the invention will now be described by means of the Figures.

Self-mixing interference is used for detecting movement of and distance to an object. Background information about self-mixing interference is described in "Laser diode self-mixing technique for sensing applications", Giuliani, G.; Norgia, M.; Donati, S. & Bosch, T., Laser diode self-mixing technique for sensing applications, Journal of Optics A: Pure and Applied Optics, 2002, 4, S. 283 - S. 2. 294.

Detection of movement of a fingertip relative to a sensor in an optical input device is described in detail in International Patent Application No. WO 02/37410.

The principle of self-mixing interference is discussed based on the examples presented in International Patent Application No. WO 02/37410. A diode laser having a laser cavity is provided for emitting a laser, or measuring, beam. At its upper side, the device is provided with a transparent window across which an object, for example a human finger, is moved. A lens is arranged between the diode laser and the window. This lens focuses the laser beam at or near the upper side of the transparent window. If an object is present at this position, it scatters the measuring beam. A part of the radiation of the measuring beam is scattered in the direction of the illumination beam and this part is converged by the lens on the emitting surface of the laser diode and re-enters the cavity of this laser. The radiation re-entering the cavity of the diode laser induces a variation in the gain of the laser and thus in the intensity of radiation emitted by the laser, and it is this phenomenon which is termed the self-mixing effect in a diode laser.

The change in intensity of the radiation emitted by the laser or of the optical wave in the laser cavity can be detected by a photo diode or a detector arranged to determine an impedance variation across the laser cavity. The diode or impedance detector converts the radiation variation into an electric signal, and electronic circuitry is provided for processing this electric signal.

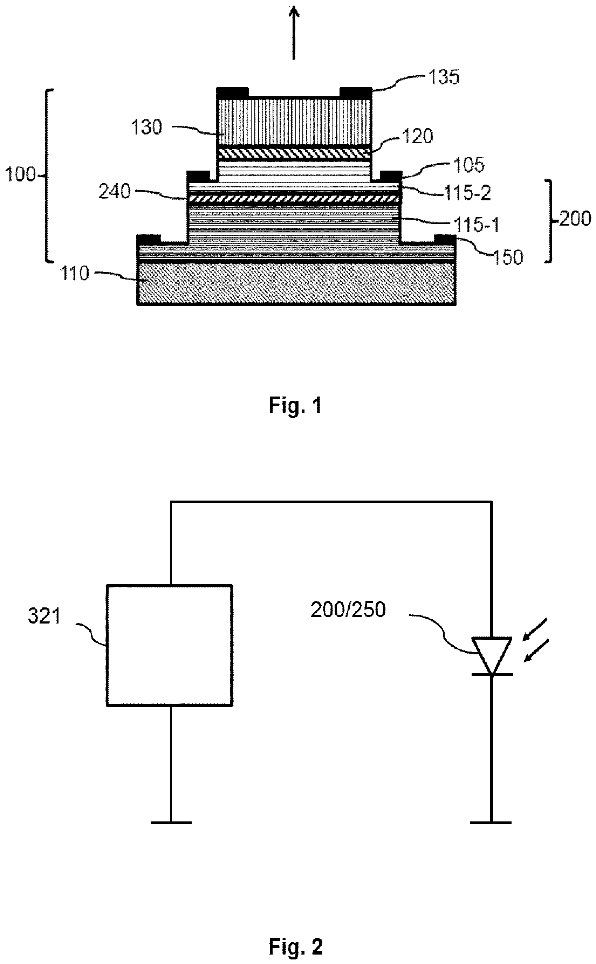

Fig. 1 shows a principal sketch of a first laser sensor module comprising a VCSEL 100 with integrated light detector 200 which may be used in particle sensor module or laser sensor for particle density detection based on self-mixing interference. The integrated light detector 200 comprises a photo diode which is at the same time arranged as an electro-optical modulator 250 (pin junction as described above). The first VCSEL 100 is provided on a substrate 110. The first VCSEL 100 comprises a first DBR 115 provided on the substrate 110. The first DBR 115 comprises a first part 115-1 and a second part 115-2. The first part 115-1 and the second part 115-2 of the first DBR 115 comprise pairs of layers with different refractive index to provide the necessary reflectivity of the first DBR 115. A light detector layer arrangement 240 (e.g. semiconductor layer arrangement building the light-sensitive part of a photo diode) is sandwiched between the first part 115-1 and the second part 115-2. An active layer 120 is sandwiched between the first DBR 115 and a second DBR 130 comprised by the VCSEL 100. The second DBR 130 comprises multiple pairs of layers with different refractive indices like the first DBR 115 to provide a somewhat lower reflectivity such that laser light is emitted via the second DBR 130 (top emitter). The active layer 120 comprises a bulk layer or quantum wells to generate laser light upon receiving a drive current by means of the first electrical contact 105 provided on an intermediate layer of the second part 115-2 of the first DBR 115 and a ring shaped second electrical contact 135 provided on top of the second DBR 130. A self-mixing interference signal may be measured by measuring the voltage between the first electrical contact 105 and an electrical contact 150 which is provided on an intermediate layer of the first part 115-1 of the first DBR 115. A tuning voltage (e.g. high-frequency signal) may be provided to the electro-optical modulator 250 by means of the first electrical contact 105 and the third electrical contact 150 which builds together with the light detector layer arrangement 240 the light detector 200. The VCSEL 100 further comprises an electrical confinement layer (current aperture which is not shown) which is in integrated in one of the DBRs 115, 130.

Fig. 2 shows a principal sketch of an embodiment of a compensation setting. A tuning circuit 321 is in the second embodiment arranged to provide to a tuning voltage (e.g. high-frequency signal) to an electro-optical modulator 250. The pulse shape of the high-frequency signal may be a harmonic (sinusoidal) high-frequency signal or the high-frequency signal may alternatively be characterized by any other suitable pulse shape (square modulation, triangular modulation and the like). Especially sawtooth modulation seems to be best suited according to the theoretical considerations to suppress false-positive particle counts which may be caused by a macroscopic object.

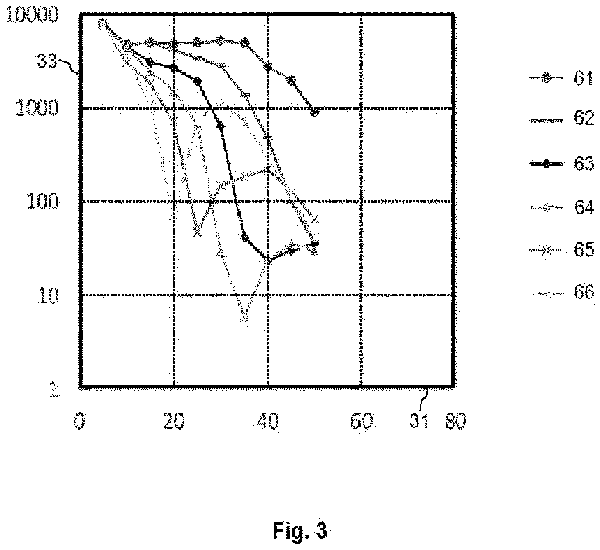

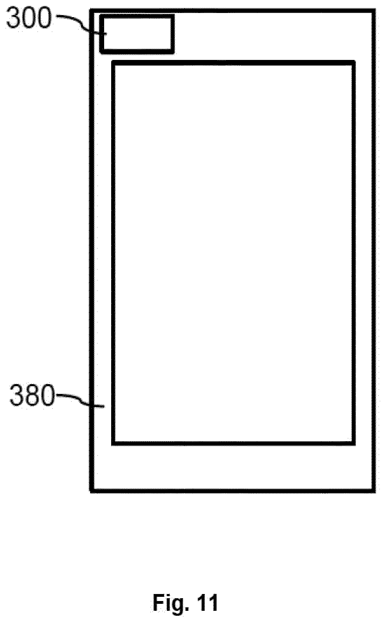

Fig. 3 shows the reduction of (false-positive) particle counts per 30 seconds 33 caused by a sheet of white paper (macroscopic object) positioned at a distance 31 by means of a tuning voltage which is in this case a high-frequency signal. Fig. 3 especially shows the modulation amplitude dependence of compensation by means of the high-frequency signal applied to the light detector 200 and electro-optical modulator 250 at a modulation frequency of 93 MHz. The ordinate shows (false-positive) particle counts per 30 seconds 33 caused by the white paper and the abscissa the distance 31 in [cm] between the particle sensor and a sheet of white paper which is used as dummy for a macroscopic object 25 (see Fig. 11). Line 61 shows a reference measurement without high-frequency voltage modulation. Line 62 is characterized by a modulation amplitude of 0.1 V, line 63 is characterized by a modulation amplitude of 0.15 V, line 64 is characterized by a modulation amplitude of 0.2 V, line 65 is characterized by a modulation amplitude of 0.25 V and line 66 is characterized by a modulation amplitude of 0.3 V. Fig. 3 shows that there is an intermediate modulation amplitude of 0.2 V (line 64) which result in the best suppression. The theoretical background of the suppression of the false-positive particle counts according to the analysis of the inventors is explained below in the theoretical considerations. The theoretical considerations are based on a current modulation of the laser (VCSEL 100) which causes a variation of the emission wavelength of the emitted laser light 315. The same theoretical considerations can be applied to a variation of the emission wavelength of the emitted laser light 315 which is caused by the electro-optical modulator 250 (variation of the optical length of the optical resonator as described above).

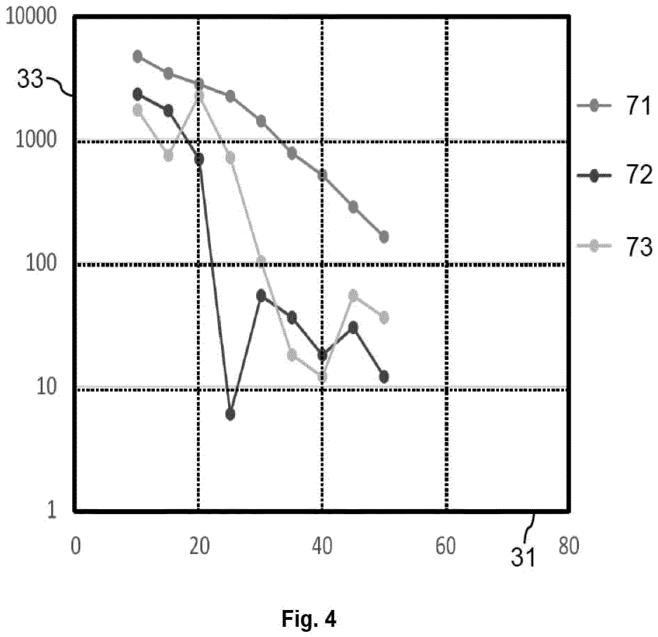

Fig. 4 shows the modulation amplitude dependence of suppression of false-positive particles counts of the second embodiment at a modulation frequency of 200 MHz. The labels of the axes are the same as discussed with respect to Fig.3. Line 71 is characterized by a modulation amplitude of 0.15 V, line 72 is characterized by a modulation amplitude of 0.3 V and line 73 is characterized by a modulation amplitude of 0.45 V. line 73 shows that the higher modulation frequency of 200 MHz gives better suppression of false-positive particle counts towards smaller distances 31 but require at the same time a higher modulation amplitude of 0.45 V in comparison to the optimum modulation amplitude of 0.2 V shown in Fig. 3. The optimum modulation amplitude therefore depends on the modulation frequency as indicated above and is well in accordance with the theoretical analysis provided below.

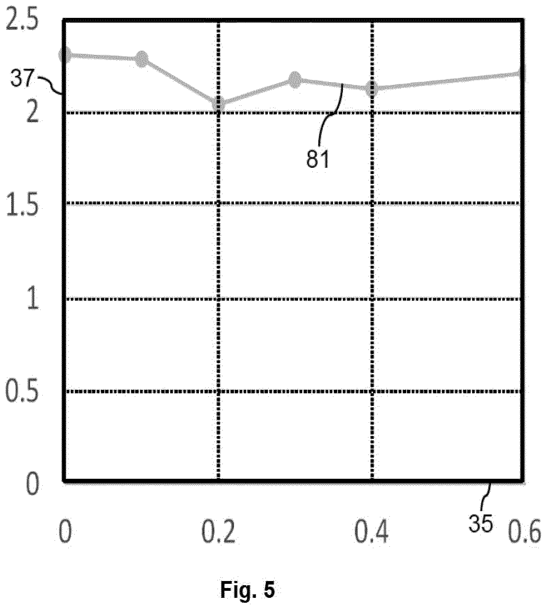

Fig. 5 shows measurement results of control measurements 81 at a modulation frequency of 93.3 MHz showing that the high-frequency signal has no effect on the count rate of the particle sensor if there is no macroscopic object. The ordinate shows the counts per second at a reference particle concentration of 33 $\mu g/m^3$ 37 and the abscissa the voltage modulation amplitude 35 in [V]. Suppression of false-positive particle counts by means of a high-frequency signal does not disturb determination of particle density and is therefore reliable.

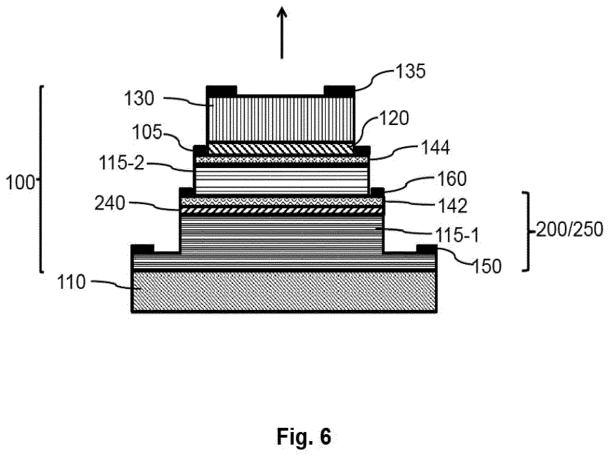

Fig. 6 shows a principal sketch of a second laser sensor module comprising a VCSEL 100 with integrated light detector 200 and electro-optical modulator 250. The light detector 200 comprises in this embodiment a pin junction as discussed above and is simultaneously be used as electro-optical modulator 250. The general configuration is similar as discussed with respect to Fig. 1. The main difference is that there is a strict separation between the electrical contacts 105, 135 used for electrically pumping the active layer 120 and the electrical contacts 150 and 160 used to contact the light detector 200 and electro-optical modulator 250. The separation of electrical contacting of the active layer 120 and the detector layer arrangement 240 may be beneficial in order to reduce crosstalk when applying the high-frequency signal. Furthermore, a first current distribution layer 142 is shown which is in direct contact with a fourth electrical contact 160 and a second current distribution layer 144 is shown which is in direct contact with the first electrical contact 105. The current distribution layers are used to tune current distribution within the VCSEL 100.

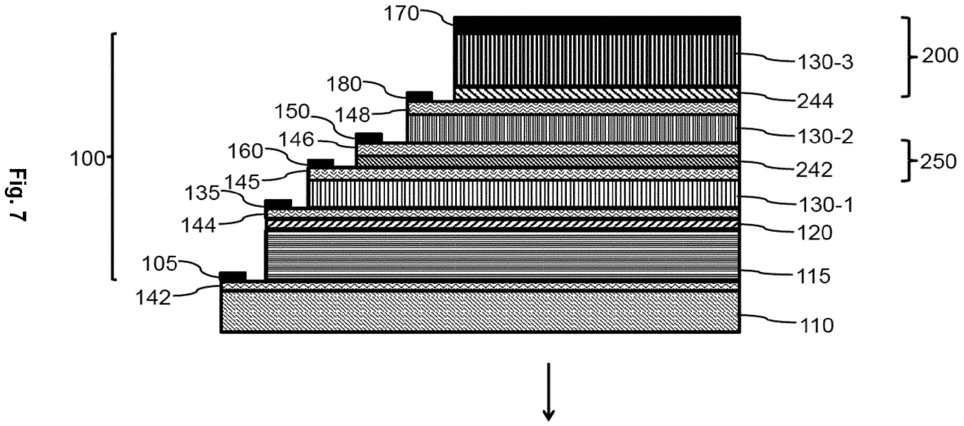

Fig. 7 shows a principal sketch of a third laser sensor module comprising a VCSEL 100 which is arranged to emit laser light via a substrate 110 (bottom emitter). The semiconductor layers of the VCSEL 100 are deposited on the substrate 110 and a first current distribution layer 142 is provided on the substrate 110. The first current distribution layer 142 is electrically contacted by means of a first electrical contact 105. A first DBR 115 is deposited on the first current distribution layer 142. An active layer 120 is provided on top of the first DBR 115. A second current distribution layer 144 is provided on top of the active layer 120. The second current distribution layer 144 is electrically connected by means of a second electrical contact 135 to enable electrical pumping of the active layer 120 by means of an electrical drive current provided via the first electrical contact 105 and the second electrical contact 135. The first DBR 115 comprises a current confinement layer (not shown) to confine the electrical drive current to a defined region of the active layer 120. A first part of a second DBR 130-1 is provided on top of the second current distribution layer 144. A third current distribution layer 145 is provided on top of the first part of the second DBR 130-1 and electrically contacted by means of a fourth electrical contact 160. A modulator layer arrangement 242 is provided on top of the third current distribution layer 145 and a fourth current distribution layer 146 is provided on top of the modulator layer arrangement 242. The fourth current distribution layer 146 is electrically contacted by means of a third electrical contact 150. The modulator layer arrangement 242 comprises at least one layer of material which is arranged such that a refractive index of this at least one layer of material can be tuned or changed by means of an electrical field applied by means of the third electrical contact 150 and the fourth electrical contact 160. The third current distribution layer 145, the modulator layer arrangement 242, the fourth current distribution layer 146 and the corresponding electrical contacts 150, 160 build an electro-optical modulator 250 with a layer thickness $\lambda$ given by the emission wavelength of the VCSEL 100 taking into account the refractive indices of the layers comprised by the electro-optical modulator 250. A second part of the second DBR 130-2 is provided on top of the fourth current distribution layer 146 and a fifth current distribution layer 148 is provided on top of the second part of the second DBR 130-2. The fifth current distribution layer 148 is electrically contacted by means of a sixth electrical contact 180. A detector layer arrangement 244 is provided on top of the fifth current distribution layer 148 and a third part of the second DBR 130-3 is provided on top of the detector layer arrangement 244. A fifth electrical contact 170 covers the third part of the second DBR 130-3. The fifth current distribution layer 148, the detector layer arrangement 244 and the third part of the second DBR 130-3 built together with the corresponding electrical contacts 170, 180 a light detector 200 (e.g. photo transistor). The electro-optical modulator 250 and the light detector 200 are in this embodiment separate devices with separate electrical contacts. The electro-optical modulator 250 may, for example, alternatively be arranged in the first DBR 115. Furthermore, the sequence of the electro-optical modulator 250 and the light detector 200 within the layer stack of the VCSEL 100 may be exchanged. The growth substrate 110 may finally be removed.

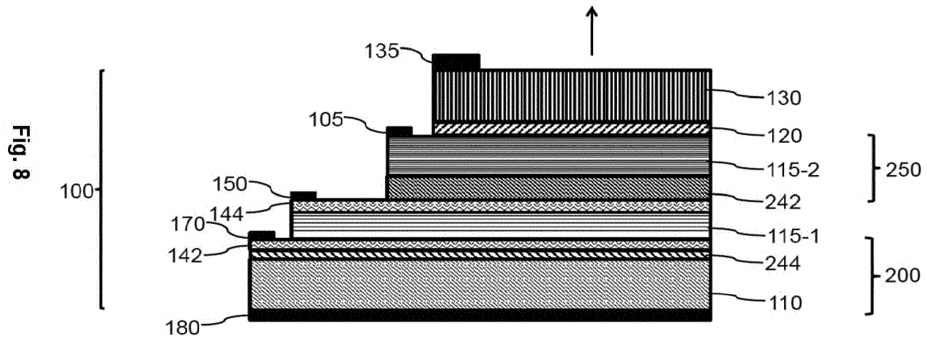

Fig. 8 shows a principal sketch of a fourth laser sensor module comprising a top emitting VCSEL 100. The VCSEL 100 comprises a substrate 110. On a first side of the substrate 110 is a sixth electrical contact 180 provided and on a second side of the substrate is a detector layer arrangement 244 provided. On top of the detector layer arrangement 244 is a first current distribution layer 142 provided which is electrically connected by means of a fifth electrical contact 170. The sixth electrical contact 180, the conductive substrate 110, the detector layer arrangement 244, the first current distribution layer 142 and the fifth electrical contact built a light detector 200 (e.g. photo diode). A first part of a first DBR 115-1 is provided on top of the first current distribution layer 142. A second current distribution layer 144 is provided on top of the first part of the first DBR 115-1. The second current distribution layer 144 is electrically connected by means of a third electrical contact 150. A modulator layer arrangement 242 similar as discussed with respect to Fig. 7 is provided on top of the second current distribution layer 144. A second part of the second DBR 115-2 is provided on top of the modulator layer arrangement 242. The uppermost layer of the second DBR 115-2 is electrically connected by means of a first electrical contact 105. The second current distribution layer, the modulator layer arrangement 242, the second part of the second DBR 115-2 and the corresponding electrical contacts 105, 150 built an electro-optical modulator 250 similar as discussed with respect to Fig. 8. An active layer 120 is provided on top of the second part of the first DBR 115-2 and a second DBR 130 is provided on top of the active layer 120. A ring shaped second electrical contact 135 is provided on the uppermost layer of the second DBR 130 to enable electrical pumping of the active layer 120 via the first electrical contact 105 and the second electrical contact 135. Other embodiments may use one electrode to contact two functional elements (laser, light detector 200, electro-optical modulator 250) of the VCSEL 100 as described, for example, with respect to Fig. 1 and Fig. 6. The third electrical contact 150 or alternatively the fifth electrical contact 170 may, for example, be used to electrically contact the light detector 200 and the electro-optical modulator 250. Design of the respective VCSEL at 100 may in this case be simplified.

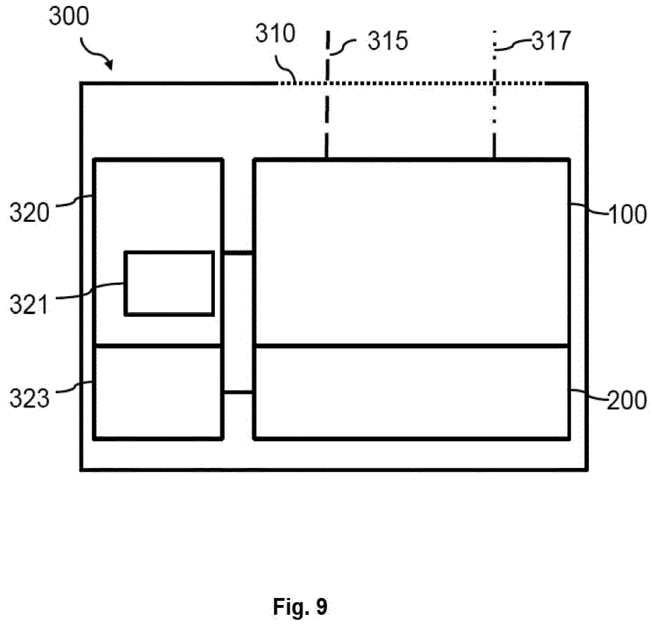

Fig. 9 shows a principal sketch of a first laser sensor 300. The first laser sensor 300 comprises a laser sensor module and a VCSEL 100 according to one embodiment described above, a transmission window 310 and a driving circuit 320 for electrically driving the VCSEL 100. The driving circuit 320 is electrically connected to the VCSEL device 100 to supply electrical power to the VCSEL device 100 in a defined way. The driving circuit 320 comprises a memory device for storing data and instructions to operate the driving circuit 320 and a processing unit for executing data and instructions to operate the driving circuit 320.

The first laser sensor 300 further comprises a tuning circuit 321 for providing a high-frequency signal to the laser (VCSEL 100). The laser sensor 300 further comprises a light detector 200 integrated in the semiconductor layer structure of the VCSEL 100 and an evaluator 323. The VCSEL 100 emits laser light 315. A part of the laser light 315 is reflected by a macroscopic object (not shown) or particles such that reflected laser light 317 enters the optical resonator of the VCSEL 100 resulting in a self-mixing interference signal which is detected by means of the light detector 200. The detected self-mixing interference signal is received and evaluated by evaluator 323 to determine a particle density. The high-frequency signal provided by the tuning circuit 321 suppresses detection of false-positive particle counts as described above which may be caused by the macroscopic object (not shown).

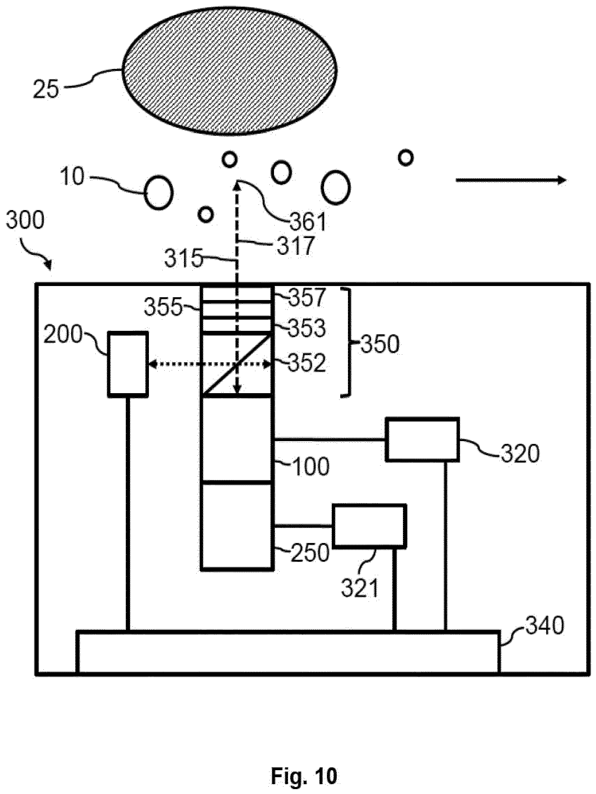

Fig. 10 shows a second laser sensor 300 which is arranged to detect a particle density and optionally macroscopic objects 25 based on interference measurements. The laser sensor 100 comprises in this embodiment and for clarity reasons only one first laser (e.g. VCSEL 100) to discuss the measurement principle. Extension to two, three or more lasers and corresponding light detectors 200 is straightforward. The first laser emits laser light to a polarizing beam splitter 352. The laser light is partly reflected at the polarizing beam splitter 352 and passes a quarter wavelength plate 353, an optical filter device 355 and a focusing device 357. The quarter wavelength plate 353 is set with its optical axis at 45° with respect to the polarization direction of the first laser. In this way, circular polarized light is made. The optical filter device 355 is characterized by a narrow passband around the emission wavelength of the first laser (e.g. 850 nm). The optical filter device 355 is optimized to suppress ambient light and is only necessary if ambient light may cause detection problems. The focusing device 357 may, for example, be a lens or a lens arrangement comprising more than one optical device. The second laser sensor 300 is arranged such that a defined part of the laser light is reflected at one of the interfaces (e.g. interface between the optical filter device 355 and air) before the laser light leaves the second laser sensor 300. The part of the laser light leaving the second laser sensor 300 is the emitted laser light 315 which is focused to the focus region 361 (measurement volume). Particles 10 reflect a part of the first emitted laser light 315 such that a part of the reflected laser light 317 reenters the second laser sensor 300. The reflected light reentering the second laser sensor 300 passes the focusing device 357, the optical filter 355 and the quarter wavelengths plate 353. Linear polarized light passes the polarizing beam splitter 352 and interferes with the laser light reflected at one of the interfaces before leaving the second laser sensor 300. A first light detector 200 (e.g. photo diode) detects the interfering light and a corresponding measurement signal is transmitted to evaluator 340. Particle density may be determined based on the number of particles determined in a given time period and the particle velocity. A tuning circuit 321 provides a high-frequency signal to the electro-optical modulator 250 as described above to suppress false-positive particle counts caused by a macroscopic object 25. The second laser sensor 300 may optionally be arranged to determine the macroscopic object 25 (e.g. finger) by switching off the high-frequency signal provided to the light detector 200 in predetermined time periods and comparing the measurement signals determined in these time periods with measurement signals in preceding or subsequent time periods.

Fig. 11 shows a principal sketch of a mobile communication device 380 comprising an optical sensor 300 similar as described with respect to Fig. 9 (comprising, for example, three lasers and corresponding light detectors 200). The optical sensor 300 can, for example, be used in combination with a software application running on the mobile communication device 380. The software application may use the optical sensor 300 to determine air-quality based on, for example, the PM 2.5 value.

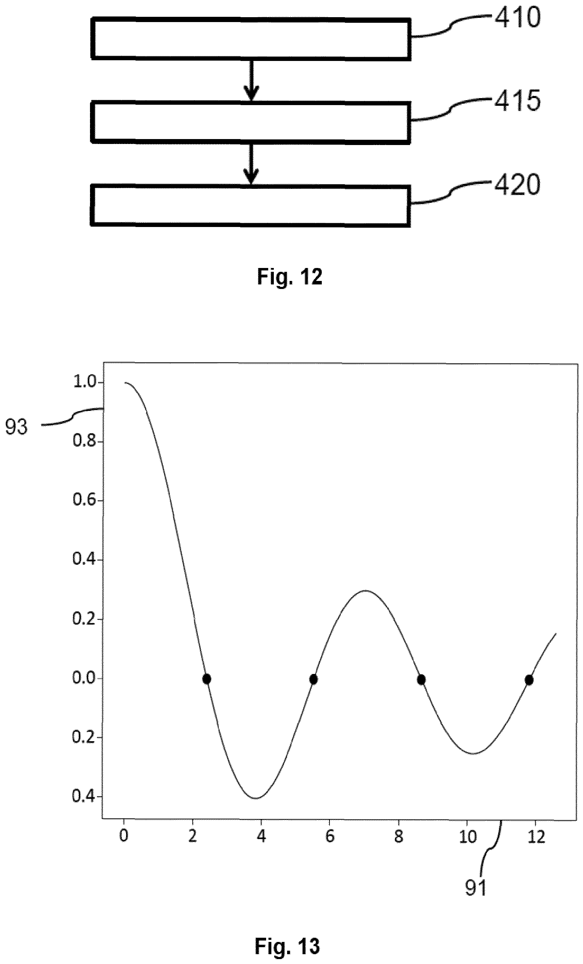

Fig. 12 shows a principal sketch of a method of particle detection using a laser sensor module according to any embodiment described above. Laser light 315 is emitted in step 410 by means of a VCSEL 100. A resonance frequency of the optical resonator is tuned by means of an electrical tuning voltage applied to the electro-optical modulator 250 in step 415. An optical response is detected in step 420 by means of the light detector 200 when tuning the resonance frequency in reaction to the laser light 315 emitted by the VCSEL 100. The tuning voltage is arranged such that a detection signal caused by a macroscopic object 25 positioned in a range between a threshold distance and a detection range of the particle sensor module is reduced in comparison to a detection signal caused by the macroscopic object 25 at the same position without providing the tuning voltage. The detection signal is received by the light detector 200 when providing the tuning voltage.

**Some theoretical considerations with respect to interference and especially self- mixing interference current modulation.**

1.1 SMI without current modulation

A simplified model is to view the SMI as interference between back reflected light from an external object and the laser light. The back reflected light can come either from a particle or from an unwanted external object.

When the object is out of focus the magnitude of the reflected light that ends up in the cavity is reduced. Unfortunately for the VIP 8.1 the distance up to which this still can influence the laser light is quite long, around 80 cm. The unwanted reflection is likely to come from an object that is not standing still on wavelength scale ($1\mu m$). This will cause the phase of the reflected light to vary and will result in a detectably intensity change in the laser light.

$$I_{tot} \propto |E_{laser} + E_{backreflected}|^2 \approx I_{laser} + E_{laser}E_{backreflected}^* + c.c. \quad (1.1)$$

$$\delta I_{SMI}(t) \propto E_{laser}E_{backreflected}^* + c.c. = E_{laser}(t)E_{laser}^*(t-\tau) + c.c. \quad (1.2)$$

$$\tau = \frac{2L}{c} \quad (1.3)$$

In case of no wavelength change the variation in laser output power results from the change in distance/phase of the backreflection, this can be expressed via a different length of the cavity, *L(t)* or a different roundtrip time, $\tau(t) = 2L(t)/c$.

$$\delta I_{SMI}(t) \propto 2Re\left(I_{laser}e^{2\pi i f\tau(t)}\right) = 2Re\left(I_{laser}e^{2\pi i \frac{2L(t)}{\lambda}}\right) \quad (1.4)$$

Both the particles and an obstruction will give rise to SMI interference effect.

1.2 SMI with current modulation

When the laser current is modulated both the amplitude and the optical frequency (or wavelength) of the laser light will change. This will also give rise to a varying laser power when the light reflects from a distant object back into the laser cavity.

The laser field can be described as

$$E(t) = e^{2\pi i f_0 t} e^{2\pi i \int_{-\infty}^{t} \delta f(t) dt} (A_0 + \delta A(t)) \quad (1.5)$$

The back reflected field has a phase that takes the additional roundtrip of the external cavity into account

$$E_{back}(t) = E(t - \tau) = e^{2\pi i f_0 (t-\tau)} e^{2\pi i \int_{-\infty}^{t-\tau} \delta f(t) dt} (A_0 + \delta A(t)) \quad (1.6)$$

The SMI term

$$E(t) E^*(t-\tau) = e^{-2\pi i f_0 \tau} e^{2\pi i \int_{t-\tau}^{t} \delta f(t) dt} \left( |A_0|^2 + A_0^* \delta A(t) + A_0 \delta A^*(t-\tau) + \delta A(t) \delta A^*(t-\tau) \right)$$
$$(1.7)$$

The first phase term is due to changes in phase due to movement of the distant reflector, the second phase term is due to frequency change from current modulation and also gives rise to interference. Note that the distance via $\tau$ influences the magnitude of the phase change due to current fluctuation.

1.3 Sinusoidal current modulation

In order to arrive at the origin of the minimum in the response to a distant object reflector, we consider the case of a sinusoidal current modulation. This leads to the following frequency modulation, $f(t) = \Delta f \cos(2\pi f_{mod} t)$. The phase modulation resulting from this is

$$\int_{t-\tau}^{t} \Delta f \cos(2\pi f_{mod} t) = \frac{\Delta f}{2\pi f_{mod}} \left( \sin(2\pi f_{mod} t) - \sin(2\pi f_{mod}(t-\tau)) \right) \quad (1.8)$$

$$= 2 \frac{\Delta f}{2\pi f_{mod}} \sin(\pi f_{mod} \tau) \cos\left( 2\pi f_{mod}(t - \frac{\tau}{2}) \right) \quad (1.9)$$

This is a periodic phase modulation. $\Delta f$ is determined by the amplitude of the current modulation, $\tau$ is determined by the roundtrip time, $2L/c$ of the external reflection, $f_{mod}$ is the modulation frequency of the current.

Using the Jacobi Anger expansion, the phase modulation can be decomposed into its harmonic components.

$$e^{iz \cos(\theta)} = \sum_{n=-\infty}^{n=\infty} J_n(z) i^n e^{in\theta}$$

$$e^{-i \frac{2\Delta f}{f_{mod}} \sin(\pi f_{mod} \tau) \cos(2\pi f_{mod}(t-\frac{\tau}{2}))} = \sum_{n=-\infty}^{n=\infty} J_n\left( \frac{2\Delta f}{f_{mod}} \sin(\pi f_{mod} \tau) \right) i^n e^{2\pi i n f_{mod}(t-\frac{\tau}{2})}$$

$$(1.10)$$

The amplitude of the frequency component is given by the Bessel function argument $J_n(\Delta f / f_{mod} \sin(\pi f_{mod} \tau))$.

1.4 SMI effect with HF current modulation

The observed effect of additional particle counts due to an obstruction is caused by the SMI effect around DC, the harmonics of the signal are at such high frequencies that the SMI spectrum around these frequencies is not visible at the detector. So in order to analyze the amplitude of the SMI effect we can concentrate on the values at low frequencies. The SMI term is

$$E(t)E^*(t-\tau) = e^{-2\pi i f_0 \tau} \left( \sum_{n=-\infty}^{n=\infty} J_n \left( \frac{2\Delta f \sin(\pi f_{mod}\tau)}{f_{mod}} \right) i^n e^{2\pi i n f_{mod}(t-\frac{\tau}{2})} \right)$$
$$(|A_0|^2 + A_0^* \Delta A e^{2\pi i f_{mod}t} + A_0 \Delta A e^{-2\pi i f_{mod}(t-\tau)} + |\Delta A|^2 \quad (1.11)$$

the first phase term corresponds to the effect of movement of distant reflector, second term contains phase modulation resulting from the current modulation, third term result from the amplitude modulation due to the current modulation

For simplicity we assume that the resulting amplitude modulation is small such that variation in amplitude can be neglected, second the variation in $\tau$ due to movement of distant reflector gives a spectrum which is considered to be low frequent with respect to the modulation frequency. The remaining DC component of the signal with these assumptions

$$(E(t)E^*(t-\tau))_{DC} = e^{-2\pi i f_0 \tau} J_0 \left( \frac{2\Delta f \sin(\pi f_{mod}\tau)}{f_{mod}} \right) |A_0|^2 \qquad (1.12)$$

The amplitude of the DC term is determined by the amplitude of the Bessel function $J_0$, and depends on the amplitude of the frequency modulation $\Delta f$ the roundtrip time of the external reflection, $\tau$, and the modulation frequency $f_{mod}$. When the argument of the Bessel function is such that its value is zero the zero order disappears. As the position where particles are detected is much closer.

Fig. 13 shows the magnitude of the DC component 93 for a given value of the argument of the zero order Bessel function 91. The dots indicate the zero crossings. When the arguments of the Bessel function are such then the DC order is missing, than where an obstruction is the particle signals have a small phase modulation and the harmonics of the frequency modulation have a very small amount of power most of the power remains around DC.

1.5 Simple laser model

In order to model the laser output due to current modulation, we model the Amplitude part and the phase part of the laser emission. The current is represented by $i(t) = i_0 + \delta i(t)$, the amplitude modulation follows from a linear dependence between output power and current,

$$\delta P(t) = \alpha \delta I(t) \qquad (1.13)$$

The coefficient $\alpha$ is the slope efficiency of the laser, the laser response to changes in current is for timescales < 1$ns$ almost instantaneous.

This in contrast to the phase response of the laser, the frequency of the laser is changed due to thermal heating effect of the current, this has a time constant of around .5 $\mu s$ (assuming a first order filter response). this results in a frequency modulation of

$$\delta f(t) = \frac{c}{\lambda_0^2} \int_0^\infty \delta i(t - t')\beta(t')dt' \qquad (1.14)$$

Here $\beta(t)$ is the impulse response of a first order filter.

In order to calculate the amount of the modulation at DC it is sufficient to calculate the DC content of the signal

$$DC\ amplitude = \int_{-\frac{T}{2}}^{\frac{T}{2}} (E(t)E^*(t-\tau) + E^*(t)E(t-\tau))dt \qquad (1.15)$$

in 1 period. (1.15) (1.15)

Here $\tau = \frac{2L}{c}$ is the delay due to the roundtrip of the external reflection of the light, and $T$ is the time of one period of the HF modulation pattern.

1.6 Special Waveform with frequencies at Nyquist

A proposal of a waveform with all frequencies at the Nyquist frequency is the following: A Square wave with the frequency at half the sample rate is multiplied by a square wave at frequency at a multiple of the sample rate.

The one period of the wave is described by the rectangular function, this function is 0, for $|t| > T/4$, 1/2, for $|t| = T/4$, and 1 for $|t| < T/4$. The Fourier transform of the rectangular function is $T/2 sinc(T/2f)$. To get a periodic function one period is multiplied by a dirac comb function, $P_{n\delta(t-nT)}$. The Fourier transform of the dirac comb is again a dirac comb with spacing $1/T$, $1/T P_{k\delta(f-k/T)}$. Using this representation, we can calculate the spectrum of this waveform.

$$\mathcal{F}\left((rect(t/T-1))\sum_{n=\infty}^{\infty}\delta(t-nT)\right) \to 1/2sinc(Tf)\sum_{k=-\infty,k\neq0}^{\infty}\delta(f-\frac{k}{T})$$

$$\mathcal{F}\left(\left((rect(t/T-1))\sum_{n=\infty}^{\infty}\delta(t-nT)\right)\left((rect(pt/T-1))\sum_{n=\infty}^{\infty}\delta(t-nT)\right)\right),$$

$$p \in \mathbb{N} \quad (1.16)$$

$$(1.17)$$

While the invention has been illustrated and described in detail in the drawings and the foregoing description, such illustration and description are to be considered illustrative or exemplary and not restrictive.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

**List of reference numerals:**

| | |
|---|---|
| 10 | particle |
| 25 | macroscopic object |
| 61 | 0 V |
| 62 | 0.1 V |
| 63 | 0.15 V |
| 64 | 0.2 V |
| 65 | 0.25 V |
| 66 | 0.3 V |
| 71 | 0.15 V |
| 72 | 0.3 V |
| 73 | 0.45 V |
| 81 | control measurement |
| 91 | argument of the zero order Bessel function |
| 93 | magnitude of the DC component |
| 100 | Vertical Cavity Surface Emitting Laser (VCSEL) |
| 105 | first electrical contact |
| 110 | substrate |
| 115 | first distributed Bragg reflector |
| 115-1 | first part of first distributed Bragg reflector |
| 115-2 | second part of first distributed Bragg reflector |
| 120 | active layer |
| 130 | second distributed Bragg reflector |
| 130-1 | first part of second distributed Bragg reflector |
| 130-2 | second part of second distributed Bragg reflector |
| 130-3 | third part of second distributed Bragg reflector |
| 135 | second electrical contact |
| 142 | first current distribution layer |
| 144 | second current distribution layer |
| 145 | third current distribution layer |

| 146 | fourth current distribution layer |
|-----|-----|
| 148 | fifth current distribution layer |
| 150 | third electrical contact |
| 155 | electrical isolation layer |
| 160 | fourth electrical contact |
| 170 | fifth electrical contact |
| 180 | sixth electrical contact |
| 200 | light detector |
| 240 | common modulator/detector layer arrangement |
| 242 | modulator layer arrangement |
| 244 | detector layer arrangement |
| 250 | electro-optical modulator |
| 300 | laser sensor |
| 310 | transmission window |
| 315 | emitted laser light |
| 317 | reflected laser light |
| 320 | driving circuit |
| 321 | tuning circuit |
| 323 | evaluator |
| 340 | interface |
| 350 | optical arrangement |
| 352 | beam splitter |
| 353 | quarter wavelength plate |
| 355 | optical filter device |
| 357 | focusing device |
| 361 | focus region |
| 380 | mobile communication device |
| 410 | step of emitting laser light |
| 415 | step of tuning optical resonator |
| 420 | step of determining optical response |

**Claims**

1. A laser sensor module for interference based particle detection comprising a Vertical Cavity Surface Emitting Laser (100), an electro-optical modulator (250) and a light detector (200), wherein the Vertical Cavity Surface Emitting Laser (100) comprises a first electrical contact (105), a second electrical contact (135) and an optical resonator, wherein the optical resonator comprises a first distributed Bragg reflector (115), a second distributed Bragg reflector (130) and an active layer (120) arranged between the first distributed Bragg reflector (115) and the second distributed Bragg reflector (130), wherein the Vertical Cavity Surface Emitting Laser (100) is arranged to emit laser light (315) during operation of the Vertical Cavity Surface Emitting Laser (100), wherein the electro-optical modulator (250) is integrated in the optical resonator, wherein the electro-optical modulator (250) is arranged to tune a resonance frequency of the optical resonator by means of an electrical tuning voltage applied to the electro-optical modulator (250), wherein the light detector (200) is arranged to detect an optical response in reaction to the laser light (315) emitted by the Vertical Cavity Surface Emitting Laser (100) and scattered or reflected back into the Vertical Cavity Surface Emitting Laser (100), wherein the tuning voltage is arranged such that a detection signal received by the light detector (200), which is caused by a macroscopic object (25) positioned in a range between a threshold distance and a detection range of the particle sensor module, is reduced, when the tuning voltage is provided, in comparison to a detection signal caused by the macroscopic object (25) at the same position, when the tuning voltage is not provided.

2. The laser sensor module according to claim 1, wherein the light detector (200) is integrated in the optical resonator.

3. The laser sensor module according to any one of the preceding claims, wherein the light detector (200) is arranged to detect a self mixing interference signal resulting from an interference of the laser light (315) emitted by the Vertical Cavity Surface Emitting Laser (100) and reflected laser light (317) in the optical resonator.

4. The laser sensor module according to 2. any one of the preceding claims, wherein the electro-optical modulator (250) comprises a semiconductor pin junction.

5. The laser sensor module according to any one of the preceding claims, wherein the electro-optical modulator (250) comprises a modulator layer arrangement (242), and wherein an optical thickness of the electro-optical modulator (250) including the modulator layer arrangement (242) is between $\lambda/2$ and five times $\lambda/2$ at the emission wavelength $\lambda$ of the Vertical Cavity Surface Emitting Laser (100).

6. The laser sensor module according to any one of the preceding claims, wherein the electro-optical modulator (250) is electrically contacted by means of a third electrical contact (150) and a fourth electrical contact (160), wherein the third electrical contact (150) and the fourth electrical contact (160) are different than the first electrical contact (105) and the second electrical contact (135).

7. The laser sensor module according to claim 6, wherein the electro-optical modulator (250) is electrically isolated from the first electrical contact (105) and the second electrical contact (135).

8. The laser sensor module according to any one of the preceding claims, wherein the electro-optical modulator (250) and the light detector (200) share the same electrical contacts (105, 150, 160).

9. The laser sensor module according to any one of claims 6-8, wherein the light detector (200) is electrically contacted by means of a fifth electrical contact (170) and a sixth electrical contact (180) wherein the fifth electrical contact (170) and the sixth electrical contact (180) are different than the first electrical contact (105), the second electrical contact (135), the third electrical contact (150) and the fourth electrical contact (160).

10. The laser sensor module according to according to claim 1, wherein the light detector (200) is separated from the Vertical Cavity Surface Emitting Laser (100) and the electro-optical modulator (250), wherein the laser sensor module comprises a beam splitter (352), and wherein the light detector (200) is arranged to detect by means of the beam splitter (352) an interference signal resulting from an interference of the laser light (315) emitted by the Vertical Cavity Surface Emitting Laser (100) and reflected laser light (317).

11. A laser sensor (300) comprising the laser sensor module according to any one of the preceding claims, wherein the laser sensor (300) comprises a driving circuit (320) connected to the first electrical contact (105) and the second electrical contact (135) for providing an electrical drive current to the Vertical Cavity Surface Emitting Laser (100), and wherein the laser sensor (300) comprises a tuning circuit (321), wherein the tuning circuit (321) is electrically connected to the electro-optical modulator (250) for providing the tuning voltage.

12. The laser sensor (300) according to claim 11, wherein the tuning circuit (321) is arranged to modulate the tuning voltage such that an electrical field in the modulator layer arrangement (242) changes on average with at least $5*10^5$ V/(m*ns), preferably at least $7.5*10^5$ V/(m*ns) for at least 0.5 ns.

13. A particle detector comprising the laser sensor (300) according to anyone of claims 11-12 and an evaluator (323), wherein the particle detector comprises an optical focusing device (357) for focusing the emitted laser light (315) to a focus region (361), wherein the focus region (361) is at a distance to the focusing device (357) of less than 3 cm, preferably less than 2 cm and most preferably less than 1 cm, wherein the distance is smaller than the threshold distance, wherein the tuning circuit (321) is arranged to provide the tuning voltage **characterized by** a modulation frequency and a modulation amplitude, wherein the modulation frequency and the modulation amplitude are arranged such that a sensitivity of the laser sensor (300) is reduced at least by one order of magnitude, preferably two orders of magnitude at a distance to the focusing device (357) between 20 cm and 40 cm, preferably between 15 cm and 50 cm, wherein the evaluator (323) is arranged to determine a particle density of particles (10) with a size between 0.05 $\mu$m to 10 $\mu$m, preferably between 0.1 $\mu$m and 2.5 $\mu$m based on measurement signals provided by the light detector (200).

14. A mobile communication device (380) comprising a laser sensor (300) according to anyone of claims 11-12 or a particle detector according to claim 13, wherein the mobile communication device (380) is arranged to communicate a particle density determined by means of the laser sensor (300) or the particle detector.

15. A method of particle detection by means of a laser sensor module comprising a Vertical Cavity Surface Emitting Laser (100), an electro-optical modulator (250) and a light detector (200), wherein the electro-optical modulator (250) is integrated in an optical resonator of the Vertical Cavity Surface Emitting Laser (100), the method comprises the steps of:

emitting laser light (315) by means of the Vertical Cavity Surface Emitting Laser (100),
tuning a resonance frequency of the optical resonator by means of an electrical tuning voltage applied to the electro-optical modulator (250),
detecting an optical response by means of the light detector (200) when tuning the resonance frequency in reaction to the laser light (315) emitted by the Vertical Cavity Surface Emitting Laser (100) and scattered or reflected back into the Vertical Cavity Surface Emitting Laser (100), wherein the tuning voltage is arranged such that a detection signal received by the light detector (200), which is caused by a macroscopic object (25) positioned in a range between a threshold distance and a detection range of the particle sensor module, is reduced, when the tuning voltage is provided, in comparison to a detection signal caused by the macroscopic object (25) at the same position, when the tuning voltage is not provided.

**Patentansprüche**

1. Lasersensormodul zur interferenzbasierten Teilchenerfassung, das einen Oberflächenemitter (100), einen elektrooptischen Modulator (250) und einen Lichtdetektor (200) umfasst, wobei der Oberflächenemitter (100) einen ersten elektrischen Kontakt (105), einen zweiten elektrischen Kontakt (135) und einen optischen Resonator umfasst, wobei der optische Resonator einen ersten verteilten Bragg-Reflektor (115), einen zweiten verteilten Bragg-Reflektor (130) und eine aktive Schicht (120), die zwischen dem ersten verteilten Bragg-Reflektor (115) und dem zweiten verteilten Bragg-Reflektor (130) eingerichtet ist, umfasst, wobei der Oberflächenemitter (100) eingerichtet ist, um Laserlicht (315) während des Betriebs des Oberflächenemitters (100) zu emittieren, wobei der elektrooptische Modulator (250) in dem optischen Resonator integriert ist, wobei der elektrooptische Modulator (250) eingerichtet ist, um eine Resonanzfrequenz des optischen Resonators mittels einer elektrischen Abstimmspannung, die an den elektrooptischen Modulator (250) angelegt wird, abzustimmen, wobei der Lichtdetektor (200) eingerichtet ist, um eine optische Reaktion als Reaktion auf das Laserlicht (315), das von dem Oberflächenemitter (100) emittiert und gestreut oder in den Oberflächenemitter (100) zurück reflektiert wird, zu erfassen, wobei die Abstimmspannung derart eingerichtet ist, dass ein Erfassungssignal, das von dem Lichtdetektor (200) empfangen wird, das von einem makroskopischen Objekt (25) verursacht wird, das in einem Bereich zwischen einem Schwellenabstand und einem Erfassungsbereich des Teilchensensormoduls positioniert ist, wenn die Abstimmspannung bereitgestellt wird, im Vergleich zu einem Erfassungssignal, das von dem makroskopischen Objekt (25) an derselben Position verursacht wird, wenn die Abstimmspannung nicht bereitgestellt wird, verringert ist.

2. Lasersensormodul nach Anspruch 1, wobei der Lichtdetektor (200) in den optischen Resonator integriert ist.

3. Lasersensormodul nach einem der vorstehenden Ansprüche, wobei der Lichtdetektor (200) eingerichtet ist, um ein selbstmischendes Interferenzsignal zu erfassen, das aus einer Interferenz des Laserlichts (315), das von dem Oberflächenemitter (100) emittiert wird, und reflektiertem Laserlicht (317) in dem optischen Resonator resultiert.

4. Lasersensormodul nach einem der vorstehenden Ansprüche, wobei der elektrooptische Modulator (250) einen Halbleiter-Pin-Übergang umfasst.

5. Lasersensormodul nach einem der vorstehenden Ansprüche, wobei der elektrooptische Modulator (250) eine Modulatorschichtanordnung (242) umfasst, und wobei eine optische Dicke des elektrooptischen Modulators (250) einschließlich der Modulatorschichtanordnung (242) zwischen $\lambda/2$ und dem Fünffachen von $\lambda/2$ bei der Emissionswellenlänge $\lambda$ des Oberflächenemitters (100) liegt.

6. Lasersensormodul nach einem der vorstehenden Ansprüche, wobei der elektrooptische Modulator (250) mittels eines dritten elektrischen Kontakts (150) und eines vierten elektrischen Kontakts (160) elektrisch kontaktiert ist, wobei der dritte elektrische Kontakt (150) und der vierte elektrische Kontakt (160) von dem ersten elektrischen Kontakt (105) und dem zweiten elektrischen Kontakt (135) unterschiedlich sind.

7. Lasersensormodul nach Anspruch 6, wobei der elektrooptische Modulator (250) von dem ersten elektrischen Kontakt (105) und dem zweiten elektrischen Kontakt (135) elektrisch isoliert ist.

8. Lasersensormodul nach einem der vorstehenden Ansprüche, wobei der elektrooptische Modulator (250) und der Lichtdetektor (200) dieselben elektrischen Kontakte (105, 150, 160) gemeinsam nutzen.

9. Lasersensormodul nach einem der Ansprüche 6-8, wobei der Lichtdetektor (200) mittels eines fünften elektrischen Kontakts (170) und eines sechsten elektrischen Kontakts (180) elektrisch kontaktiert ist, wobei der fünfte elektrische Kontakt (170) und der sechste elektrische Kontakt (180) von dem ersten elektrischen Kontakt (105), dem zweiten elektrischen Kontakt (135), dem dritten elektrischen Kontakt (150) und dem vierten elektrischen Kontakt (160) unterschiedlich sind.

10. Lasersensormodul nach Anspruch 1, wobei der Lichtdetektor (200) von dem Oberflächenemitter (100) und dem elektrooptischen Modulator (250) getrennt ist, wobei das Lasersensormodul einen Strahlenteiler (352) umfasst, und wobei der Lichtdetektor (200) eingerichtet ist, um mittels des Strahlenteilers (352) ein Interferenzsignal, das aus einer Interferenz des Laserlichts (315), das von dem Oberflächenemitter (100) emittiert wird, und reflektiertem Laserlicht (317) resultiert, erfasst.

11. Lasersensor (300), der das Lasersensormodul nach einem der vorstehenden Ansprüche umfasst, wobei der Lasersensor (300) eine Treiberschaltung (320) umfasst, die mit dem ersten elektrischen Kontakt (105) und dem zweiten elektrischen Kontakt (135) verbunden ist, um einen elektrischen Antriebsstrom für den Oberflächenemitter (100) bereitzustellen, und wobei der Lasersensor (300) eine Abstimmschaltung (321) umfasst, wobei die Abstimmschaltung (321) elektrisch mit dem elektrooptischen Modulator (250) verbunden ist, um die Abstimmspannung bereitzustellen.

12. Lasersensor (300) nach Anspruch 11, wobei die Abstimmschaltung (321) eingerichtet ist, um die Abstimmspannung derart zu modulieren, dass ein elektrisches Feld in der Modulatorschichtanordnung (242) im Mittel mit mindestens $5*10^5$ V/(m*ns), bevorzugt mindestens $7,5*10^5$ V/(m*ns), für mindestens 0,5 ns wechselt.

13. Teilchendetektor, der den Lasersensor (300) nach einem der Ansprüche 11-12 und eine Bewerter (323) umfasst, wobei der Teilchendetektor eine optische Fokussiervorrichtung (357) zum Fokussieren des emittierten Laserlichts (315) zu einem Fokusbereich umfasst (361), wobei der Fokusbereich (361) einen Abstand zu der Fokussiervorrichtung (357) von weniger als 3 cm, bevorzugt weniger als 2 cm und ganz besonders bevorzugt weniger als 1 cm aufweist, wobei der Abstand kleiner ist als der Schwellenabstand, wobei die Abstimmschaltung (321) eingerichtet ist, um die Abstimmspannung bereitzustellen, die von einer Modulationsfrequenz und einer Modulationsamplitude gekennzeichnet ist, wobei die Modulationsfrequenz und die Modulationsamplitude derart eingerichtet sind, dass eine Empfindlichkeit des Lasersensors (300) mindestens um eine Größenordnung, bevorzugt zwei Größenordnungen in einem Abstand zu der Fokussiervorrichtung (357) zwischen 20 cm und 40 cm, bevorzugt zwischen 15 cm und 50 cm, verringert ist, wobei der Bewerter (323) eingerichtet ist, um eine Teilchendichte von Teilchen (10) mit einer Größe zwischen 0,05 $\mu$m bis 10 $\mu$m, bevorzugt zwischen 0,1 $\mu$m und 2,5 $\mu$m, basierend auf Messsignalen, die von dem Lichtdetektor (200) bereitgestellt werden, zu ermitteln.

14. Mobilkommunikationsvorrichtung (380), die einen Lasersensor (300) nach einem der Ansprüche 11-12 oder einem Teilchendetektor nach Anspruch 13 umfasst, wobei die Mobilkommunikationsvorrichtung (380) eingerichtet ist, um eine Teilchendichte zu übermitteln, die mittels des Lasersensors (300) oder des Teilchendetektors ermittelt wird.

15. Verfahren zur Teilchenerfassung mittels eines Lasersensormoduls, das einen Oberflächenemitter (100), einen elektrooptischen Modulator (250) und einen Lichtdetektor (200) umfasst, wobei der elektrooptische Modulator (250) in einem optischen Resonator des Oberflächenemitters (100) integriert ist, wobei das Verfahren die Schritte umfasst:

Emittieren von Laserlicht (315) mittels des Oberflächenemitters (100),
Abstimmen einer Resonanzfrequenz des optischen Resonators mittels einer elektrischen Abstimmspannung, die an den elektrooptischen Modulator (250) angelegt wird,
Erfassen einer optischen Reaktion mittels des Lichtdetektors (200), wenn die Resonanzfrequenz als Reaktion auf das Laserlicht (315), das von dem Oberflächenemitter (100) emittiert und gestreut oder in den Oberflächenemitter (100) zurück reflektiert wird, abgestimmt wird, wobei die Abstimmspannung derart eingerichtet ist, dass ein Erfassungssignal, das von dem Lichtdetektor (200) empfangen wird, das von einem makroskopischen Objekt (25) verursacht wird, das in einem Bereich zwischen einem Schwellenabstand und einem Erfassungsbereich des Teilchensensormoduls positioniert ist, wenn die Abstimmspannung bereitgestellt wird, im Vergleich zu einem Erfassungssignal, das von dem makroskopischen Objekt (25) an derselben Position verursacht wird, wenn die Abstimmspannung nicht bereitgestellt wird, verringert wird.

**Revendications**

1. Module de capteur laser pour la détection de particules basée sur des interférences comprenant un laser à cavité verticale émettant par la surface (100), un modulateur électro-optique (250) et un détecteur de lumière (200), dans lequel le laser à cavité verticale émettant par la surface (100) comprend un premier contact électrique (105), un deuxième contact électrique (135) et un résonateur optique, dans lequel le résonateur optique comprend un premier réflecteur réparti de Bragg (115), un second réflecteur réparti de Bragg (130) et une couche active (120) disposée entre le premier réflecteur réparti de Bragg (115) et le second réflecteur réparti de Bragg (130), dans lequel le laser à cavité verticale émettant par la surface (100) est agencé pour émettre une lumière laser (315) pendant le fonctionnement du laser à cavité verticale émettant par la surface (100), dans lequel le modulateur électro-optique (250) est intégré dans le résonateur optique, dans lequel le modulateur électro-optique (250) est agencé pour syntoniser une fréquence de résonance du résonateur optique au moyen d'une tension électrique de syntonisation appliquée au modulateur électro-optique (250), dans lequel le détecteur de lumière (200) est agencé pour détecter une réponse optique en réaction à l'émission de lumière laser (315) par le laser à cavité verticale émettant par la surface (100) et à la diffusion ou à la réflexion dans le laser à cavité verticale émettant par la surface (100), dans lequel la tension de syntonisation est agencée, de sorte qu'un signal de détection reçu par le détecteur de lumière (200), provoqué par un objet macroscopique (25) positionné dans une plage comprise entre une distance seuil et une plage de détection du module de capteur de particules, soit réduit en présence de la tension de syntonisation, par rapport à un signal de détection provoqué par l'objet macroscopique (25) à la même position en l'absence de la tension de syntonisation.

2. Module de capteur laser selon la revendication 1, dans lequel le détecteur de lumière (200) est intégré au résonateur optique.

3. Module de capteur laser selon l'une quelconque des revendications précédentes, dans lequel le détecteur de lumière (200) est agencé pour détecter un signal d'interférence à mélange automatique résultant d'une interférence de la lumière laser (315) émise par le laser à cavité verticale émettant par la surface (100) et de la lumière laser réfléchie (317) dans le résonateur optique.

4. Module de capteur laser selon l'une quelconque des revendications précédentes, dans lequel le modulateur électro-optique (250) comprend une jonction à broche semi-conductrice.

5. Module de capteur laser selon l'une quelconque des revendications précédentes, dans lequel le modulateur électro-optique (250) comprend un agencement de couche de modulateur (242) et dans lequel une épaisseur optique du modulateur électro-optique (250) comprenant l'agencement de couche de modulateur (242) est comprise entre $\lambda/2$ et cinq fois $\lambda/2$ à la longueur d'onde d'émission A du laser à cavité verticale émettant par la surface (100).

6. Module de capteur laser selon l'une quelconque des revendications précédentes, dans lequel le modulateur électro-optique (250) est mis en contact électrique au moyen d'un troisième contact électrique (150) et d'un quatrième contact électrique (160), dans lequel le troisième contact électrique (150) et le quatrième contact électrique (160) sont différents du premier contact électrique (105) et du deuxième contact électrique (135).

7. Module de capteur laser selon la revendication 6, dans lequel le modulateur électro-optique (250) est isolé électriquement du premier contact électrique (105) et du deuxième contact électrique (135).

8. Module de capteur laser selon l'une quelconque des revendications précédentes, dans lequel le modulateur électro-optique (250) et le détecteur de lumière (200) partagent les mêmes contacts électriques (105, 150, 160).

9. Module de capteur laser selon l'une quelconque des revendications 6 à 8, dans lequel le détecteur de lumière (200) est mis en contact électrique au moyen d'un cinquième contact électrique (170) et d'un sixième contact électrique (180), dans lequel le cinquième contact électrique (170) et le sixième contact électrique (180) sont différents du premier contact électrique (105), du deuxième contact électrique (135), du troisième contact électrique (150) et du quatrième contact électrique (160).

10. Module de capteur laser selon la revendication 1, dans lequel le détecteur de lumière (200) est séparé du laser à cavité verticale émettant par la surface (100) et du modulateur électro-optique (250), dans lequel le module de capteur laser comprend un diviseur de faisceau (352) et dans lequel le détecteur de lumière (200) est agencé pour détecter, au moyen du diviseur de faisceau (352), un signal d'interférence résultant d'une interférence de la lumière laser (315) émise par le laser à cavité verticale émettant par la surface (100) et de la lumière laser réfléchie (317).

11. Capteur laser (300) comprenant le module de capteur laser selon l'une quelconque des revendications précédentes, le capteur laser (300) comprenant un circuit de commande (320) connecté au premier contact électrique (105) et au deuxième contact électrique (135) pour fournir un courant d'excitation électrique au laser à cavité verticale émettant par la surface (100) et le capteur laser (300) comprenant un circuit de syntonisation (321), le circuit de syntonisation (321) étant électriquement connecté au modulateur électro-optique (250) pour fournir la tension de syntonisation.

12. Capteur laser (300) selon la revendication 11, dans lequel le circuit de syntonisation (321) est agencé pour moduler la tension de syntonisation, de sorte qu'un champ électrique dans l'agencement de couche de modulateur (242) varie en moyenne avec au moins $5*10^5$ V/(m*ns), de préférence avec au moins $7,5*10^5$ V/(m*ns) pendant au moins 0,5 ns.

13. Détecteur de particules comprenant le capteur laser (300) selon l'une quelconque des revendications 11 à 12 et un évaluateur (323), le détecteur de particules comprenant un dispositif de focalisation optique (357) permettant de focaliser la lumière laser émise (315) sur une zone de focalisation (361), la zone de focalisation (361) étant à une distance du dispositif de focalisation (357) de moins de 3 cm, de préférence de moins de 2 cm et au mieux de moins de 1 cm, la distance étant inférieure à la distance seuil, le circuit de syntonisation (321) étant agencé pour fournir la tension de syntonisation **caractérisée par** une fréquence de modulation et par une amplitude de modulation, la fréquence de modulation et l'amplitude de modulation étant agencées de sorte qu'une sensibilité du capteur laser (300) soit réduite d'au moins un ordre de grandeur, de préférence de deux ordres de grandeur à une distance par rapport au dispositif de focalisation (357) comprise entre 20 cm et 40 cm, de préférence entre 15 cm et 50 cm, l'évaluateur (323) étant agencé pour déterminer une densité particulaire de particules (10) d'une taille comprise entre 0,05 $\mu$m et 10 $\mu$m, de préférence entre 0,1 $\mu$m et 2,5 $\mu$m en fonction des signaux de mesure fournis par le détecteur de lumière (200).

14. Dispositif de communication mobile (380) comprenant un capteur laser (300) selon l'une quelconque des revendications 11 à 12 ou un détecteur de particules selon la revendication 13, le dispositif de communication mobile (380) étant agencé pour communiquer une densité de particules déterminée au moyen du capteur laser (300) ou du détecteur de particules.

15. Procédé de détection de particules au moyen d'un module de capteur laser comprenant un laser à cavité verticale émettant par la surface (100), un modulateur électro-optique (250) et un détecteur de lumière (200), dans lequel le modulateur électro-optique (250) est intégré à un résonateur optique du laser à cavité verticale émettant par la surface (100), le procédé comprend les étapes suivantes :

émission de lumière laser (315) au moyen du laser à cavité verticale émettant par la surface (100),
syntonisation d'une fréquence de résonance du résonateur optique au moyen d'une tension de syntonisation électrique appliquée au modulateur électro-optique (250),
détection d'une réponse optique au moyen du détecteur de lumière (200) lors de la syntonisation de la fréquence de résonance en réaction à la lumière laser (315) émise par le laser à cavité verticale émettant par la surface (100) et diffusée ou réfléchie dans le laser à cavité verticale émettant par la surface (100), dans lequel la tension de syntonisation est agencée de sorte qu'un signal de détection reçu par le détecteur de lumière (200), provoqué par un objet macroscopique (25) positionné dans une plage comprise entre une distance seuil et une plage de détection du module de capteur de particules, soit réduit, en présence de la tension de syntonisation, par rapport à un signal de détection provoqué par l'objet macroscopique (25) à la même position, en l'absence de la tension de syntonisation.

**Fig. 1**

**Fig. 2**

**Fig. 3**

Fig. 4

**Fig. 5**

**Fig. 6**

**Fig. 7**

Fig. 8

**Fig. 9**

EP 3 814 743 B1

**Fig. 10**

300

380

**Fig. 11**

**Fig. 12**

**Fig. 13**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102015207289 A1
- WO 2017198699 A1
- WO 2017198555 A1
- WO 2017016888 A1
- WO 0237410 A

**Non-patent literature cited in the description**

- **GIULIANI, G. ; NORGIA, M. ; DONATI, S. ; BOSCH, T.** Laser diode self-mixing technique for sensing applications. *Journal of Optics A: Pure and Applied Optics,* 2002, vol. 4, 283-294